# EUROPEAN PATENT SPECIFICATION

(11) **EP 4 176 999 B1**
(45) Date of publication and mention of the grant of the patent: **26.11.2025**
(21) Application number: 22201650.3
(22) Date of filing: 14.10.2022
(51) Int. Cl.: B23K 26/00, B23K 26/0622, B23K 26/08, B23K 26/354, H01L 21/02, B23K 101/34, B23K 101/36, B23K 101/40, B23K 103/16, B23K 103/00

(54) **LASER CRYSTALLIZATION DEVICE, LASER CRYSTALLIZATION METHOD AND METHOD OF MANUFACTURING DISPLAY DEVICE, WITH USE OF THREE SOLID STATE LASERS**
LASERKRISTALLISATIONSVORRICHTUNG, LASERKRISTALLISATIONSVERFAHREN UND VERFAHREN ZUR HERSTELLUNG EINER ANZEIGEVORRICHTUNG,UNTER VERWENDUNG VON DREI FESTKÖRPERLASERN
DISPOSITIF DE CRISTALLISATION LASER, PROCÉDÉ DE CRISTALLISATION LASER ET PROCÉDÉ DE FABRICATION DE DISPOSITIF D'AFFICHAGE, AVEC UTILISATION DE TROIS LASERS À ÉTAT SOLIDE

(30) Priority: 15.10.2021 KR 20210137355
(43) Date of publication of application: 10.05.2023
(73) Proprietor: Samsung Display Co., Ltd., Yongin-si, Gyeonggi-do 17113 (KR)
(72) Inventor: LEE, Dong-Min, Yongin-si (KR); KIM, Jang-Hyun, Hwaseong-si (KR); SO, Byung Soo, Yongin-si (KR); JEONG, Jaewoo, Suwon-si (KR); JIN, Donggyu, Hwaseong-si (KR)
(74) Representative: Marks & Clerk LLP

(56) References cited:
- US-A1- 2003 112 322
- US-A1- 2016 126 457
- US-A1- 2021 069 824

## Description

### BACKGROUND

### 1. Field

Embodiments relate to a laser crystallization device, a laser crystallization method and a method of manufacturing a display device, see claims 1, 4 and 7. More particularly, embodiments relate to a laser crystallization device, a laser crystallization method and a method of manufacturing a display device that perform solid-state laser crystallization.

### 2. Description of the Related Art

A display device may include a driving element and a light emitting element to emit light. The driving element may include a transistor and a capacitor. The light emitting element may include an organic light emitting element and an inorganic light emitting element. The light emitting element may be connected to the driving element to receive a signal. The transistor may include silicon. Silicon may include amorphous silicon and polycrystalline silicon. Amorphous silicon may be crystallized into polycrystalline silicon by a laser.

In such a display device, the luminous efficiency of the display device may vary according to the degree of crystallization of polycrystalline silicon. Accordingly, research is being conducted to increase the crystallinity of polycrystalline silicon. Prior art document 1 [US 2021/069824 A1, describing the preamble of claims 1 and 4] discloses a laser processing apparatus and a laser processing method that can effectively prevent a processing time for one semiconductor film from increasing. The apparatus comprises a laser processing apparatus, a laser light source configured to irradiate a semiconductor film with a laser beam, a film state measuring instrument configured to measure a state of the semiconductor film after the semiconductor film and a laser light adjusting mechanism. Prior art document 2 [US 2003/112322 A1] discloses a laser beam irradiating apparatus comprising a plurality of lasers, a member for synthesizing a plurality of laser beams emitted respectively from the plurality of lasers into a single laser beam on a stage and a member for moving the synthesized laser beam on the stage while keeping a specific shape.

### SUMMARY

A laser crystallisation device according to a first aspect of the invention is defined in claim 1.

A laser crystallisation method according to a second aspect of the present invention is defined in claim 4.

And a method of manufacturing according to a third aspect of the present invention is defined in claim 7.

Further preferred embodiments of the present invention are defined in the dependent claims.

### BRIEF DESCRIPTION OF THE DRAWINGS

The above and other features of the invention will become more apparent by describing in further detail embodiments thereof with reference to the accompanying drawings, in which:
FIG 1 is a plan view illustrating a display device according to an embodiment;
FIG 2 is a cross-sectional view illustrating an embodiment of the display device of FIG 1 taken along line I-I';
FIG 3 is a perspective view illustrating an embodiment of a laser crystallization device for forming an active layer included in the display device of FIG 2;
FIG 4 is a view illustrating an embodiment of the laser crystallization device of FIG 3;
FIG 5 is a view illustrating an energy intensity of a laser generated in the laser crystallization device of FIG 4;
FIG 6 is a view illustrating a temperature of a preliminary active layer crystallized by a laser generated in the laser crystallization device of FIG 4;
FIG 7 is a flowchart illustrating an embodiment of a laser crystallization method; and
FIGS. 8, 9, 10 and 11 are cross-sectional views illustrating an embodiment of a method of manufacturing the display device.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the claims.

Hereinafter, embodiments of the disclosure will be described in detail with reference to the accompanying drawings.

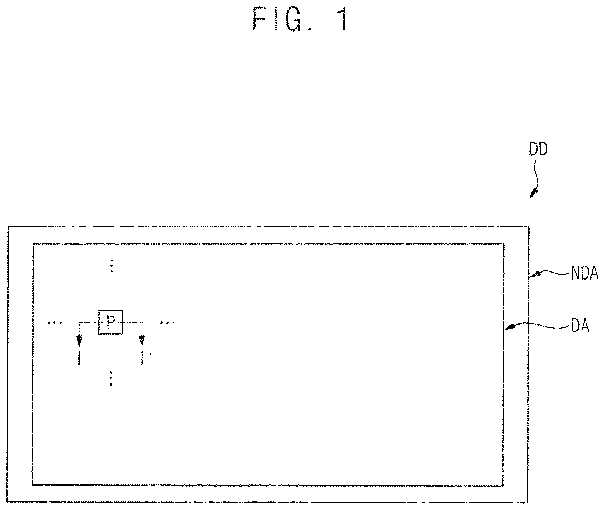

FIG 1 is a plan view illustrating a display device according to an embodiment.

Referring to FIG 1, an embodiment of the display device DD may include a display area DA and a non-display area NDA. The non-display area NDA may be disposed to surround the display area DA. Alternatively, the non-display area NDA may be disposed only on at least one side of the display area DA.

A plurality of pixels P may be disposed in the display area DA. Each of the plurality of pixels P may include a driving element and a light emitting element. The light emitting element may be connected to the driving element. The light emitting element may emit light by receiving a signal from the driving element. The driving element may include a transistor and a capacitor. The light emitting element may include an organic light emitting diode or an inorganic light emitting diode. As the plurality of pixels P emit light, the display device DD may display an image in the display area DA. The plurality of pixels P may be entirely arranged in the display area DA. In an embodiment, for example, the plurality of pixels P may be arranged in a matrix form in the display area DA, for example, but not being limited thereto. Alternatively, the plurality of pixels P may be generally disposed in the display area DA in various ways.

Drivers for driving the plurality of pixels P may be disposed in the non-display area NDA. The drivers may include a data driver, a gate driver, a light emitting driver, a power voltage generator, a timing controller, and the like. The drivers may be connected to a plurality of pixels P. The plurality of pixels P may emit light based on signals received from the drivers.

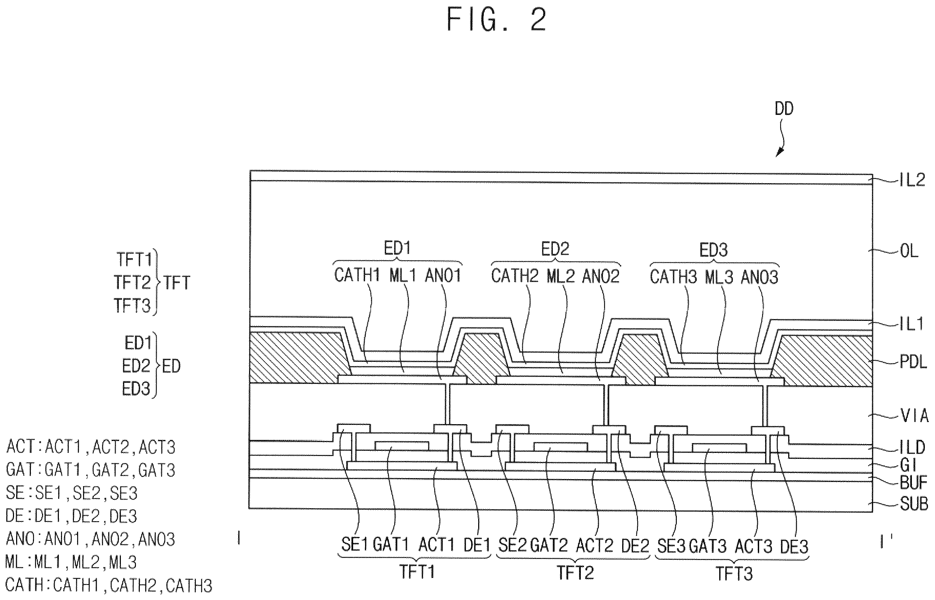

FIG 2 is a cross-sectional view illustrating an embodiment of the display device of FIG 1 taken along line I-I'.

Referring to FIG 2, an embodiment of the display device DD may include a substrate SUB, a buffer layer BUF, a driving element TFT, a gate insulating layer GI, an interlayer insulating layer ILD, a via insulating layer VIA, a light emitting element ED, a pixel defining layer PDL and a thin film encapsulation layer.

The driving element TFT may include a first transistor TFT1, a second transistor TFT2, and a third transistor TFT3. The light emitting element ED may include a first light emitting element ED1, a second light emitting element ED2, and a third light emitting element ED3.

The first transistor TFT1 may include a first active layer ACT1, a first gate electrode GAT1, a first source electrode SE1, and a first drain electrode DE1. The second transistor TFT2 may include a second active layer ACT2, a second gate electrode GAT2, a second source electrode SE2, and a second drain electrode DE2. The third transistor TFT3 may include a third active layer ACT3, a third gate electrode GAT3, a third source electrode SE3, and a third drain electrode DE3. The active layer ACT may include a first active layer ACT1, a second active layer ACT2, and a third active layer ACT3. The gate electrode GAT may include a first gate electrode GAT1, a second gate electrode GAT2, and a third gate electrode GAT3. The source electrode SE may include a first source electrode SE1, a second source electrode SE2, and a third source electrode SE3. The drain electrode DE may include a first drain electrode DE1, a second drain electrode DE2, and a third drain electrode DE3.

The first light emitting element ED1 may include a first anode electrode ANO1, a first intermediate layer ML1, and a first cathode electrode CATH1. The second light emitting element ED2 may include a second anode electrode ANO2, a second intermediate layer ML2, and a second cathode electrode CATH2. The third light emitting element ED3 may include a third anode electrode ANO3, a third intermediate layer ML3, and a third cathode electrode CATH3. The anode electrode ANO may include a first anode electrode ANO1, a second anode electrode ANO2, and a third anode electrode ANO3. The intermediate layer ML may include a first intermediate layer ML1, a second intermediate layer ML2, and a third intermediate layer ML3. The cathode electrode CATH may include a first cathode electrode CATH1, a second cathode electrode CATH2, and a third cathode electrode CATH3. The cathode electrode CATH (e.g., the first cathode electrode CATH1, the second cathode electrode CATH2, and the third cathode electrode CATH3) may be integrally formed as a single unitary unit.

The thin film encapsulation layer may include a first inorganic layer IL1, an organic layer OL, and a second inorganic layer IL2. In an embodiment, as shown in FIG 2, the thin film encapsulation layer may be defined by three layers, but not being limited thereto. Alternatively, the thin film encapsulation layer may further include separate inorganic layers and organic layers.

The substrate SUB may include a flexible material or a rigid material. In an embodiment, for example, the substrate SUB may include a polymer material such as polyimide, such that the substrate SUB may have a flexible characteristic. Alternatively, for example, the substrate SUB may include a material such as glass, and in this case, the substrate SUB may have a rigid characteristic.

The buffer layer BUF may be disposed on the substrate SUB. The buffer layer BUF may include an inorganic insulating material. In an embodiment, for example, the buffer layer BUF may include at least one selected from silicon oxide (SiOx), silicon nitride (SiNx), silicon oxynitride (SiON), and the like. These may be used alone or in combination with each other. The buffer layer BUF may prevent metal atoms or impurities from diffusing into the active layer ACT. In such an embodiment, the buffer layer BUF controls the speed of heat provided to the active layer ACT during the crystallization process for forming the active layer ACT.

The active layer ACT may be disposed on the buffer layer BUF. In an embodiment, the active layer ACT may include a silicon semiconductor. In such an embodiment, the silicon semiconductor may include amorphous silicon, polycrystalline silicon, or the like, for example.

The amorphous silicon may have a low electron mobility of about 1 square centimeter per volt second (cm²/Vs) or less. The polycrystalline silicon may have an electron mobility greater than that of the amorphous silicon. Accordingly, in an embodiment, the active layer ACT may include the polycrystalline silicon.

The polycrystalline silicon may be formed by radiating a laser to the amorphous silicon. When a laser is radiated to the amorphous silicon, the amorphous silicon may be crystallized into polycrystalline silicon.

The light emitting performance of the display device DD may vary according to the degree of crystallization of the polycrystalline silicon. In an embodiment, where the polycrystalline silicon is formed by radiating a laser to the amorphous silicon, if the polycrystalline silicon is not sufficiently crystallized, light emitted from the light emitting element may be stained. Therefore, in an embodiment of the invention, a laser may be radiated to the amorphous silicon in a way such that such defects are effectively prevented.

The gate insulating layer GI may be disposed on the buffer layer BUF. The gate insulating layer GI may be disposed to cover the active layer ACT. The gate insulating layer GI may include an inorganic insulating material.

The gate electrode GAT may be disposed on the gate insulating layer GI. The gate electrode GAT may partially overlap the active layer ACT. In response to a gate signal provided to the gate electrode GAT, a signal and/or a voltage may flow through the active layer ACT. In an embodiment, the gate electrode GAT may include a metal, a metal oxide, or a metal nitride. In an embodiment, where the gate electrode GAT includes a metal, the metal may include at least one selected from silver (Ag), molybdenum (Mo), aluminium (Al), tungsten (W), copper (Cu), nickel (Ni), chromium (Cr), titanium (Ti), tantalum (Ta), platinum (Pt), scandium (Sc), and the like, for example. These may be used alone or in combination with each other. In an embodiment, where the gate electrode GAT includes a metal oxide, the metal oxide may include at least one selected from indium tin oxide ("ITO"), indium zinc oxide ("IZO"), and the like, for example. These may be used alone or in combination with each other. In an embodiment, where the gate electrode GAT includes a metal nitride, the metal nitride may include at least one selected from aluminium nitride (AlN), tungsten nitride (WN), and chromium nitride (CrN), for example. These may be used alone or in combination with each other.

The interlayer insulating layer ILD may be disposed on the gate insulating layer GI. The interlayer insulating layer ILD may be disposed to cover the gate electrode GAT. The interlayer insulating layer ILD may include an inorganic insulating material.

The source electrode SE and the drain electrode DE may be disposed on the interlayer insulating layer ILD. The first source electrode SE1 and the first drain electrode DE1 may be respectively connected to the first active layer ACT1 through a contact hole defined through the gate insulating layer GI and the interlayer insulating layer ILD. The second source electrode SE2 and the second drain electrode DE2 may be respectively connected to the second active layer ACT2 through a contact hole defined through the gate insulating layer GI and the interlayer insulating layer ILD. The third source electrode SE3 and the third drain electrode DE3 may be respectively connected to the third active layer ACT3 through a contact hole defined through the gate insulating layer GI and the interlayer insulating layer ILD. Each of the source electrode SE and the drain electrode DE may include a metal, a metal oxide, a metal nitride, or the like, for example.

The via insulating layer VIA may be disposed on the interlayer insulating layer ILD. The via insulating layer VIA may be disposed to cover the source electrode SE and the drain electrode DE. The via insulating layer VIA may have a substantially flat top surface. In an embodiment, the via insulating layer VIA may include an organic insulating material. In such an embodiment, the organic insulating material may include at least one selected from polyacrylic resins, polyimide resins, and acrylic resins, for example. These may be used alone or in combination with each other.

The anode electrode ANO may be disposed on the via insulating layer VIA. The anode electrode ANO may be connected to the drain electrode DE through a contact hole defined through the via insulating layer VIA. The anode electrode ANO may include a metal, a metal oxide, or a metal nitride.

The pixel defining layer PDL may be disposed on the via insulating layer VIA. An opening exposing each of the first to third anode electrodes ANO1, ANO2, and ANO3 may be defined or formed in the pixel defining layer PDL. The pixel defining layer PDL may include an organic insulating material.

The intermediate layer ML may be disposed on the anode electrode ANO. The intermediate layer ML may include an organic material that emits light of a preset color. The intermediate layer ML may emit the light based on a potential difference between the anode electrode ANO and the cathode electrode CATH. The intermediate layer ML may include an electron injection layer, an electron transport layer, a light emitting layer, a hole transport layer, and a hole injection layer, for example.

The first to third light emitting elements ED1, ED2, ED3 may emit light having a same color as each other. In an embodiment, for example, all of the first to third light emitting elements ED1, ED2, and ED3 may emit blue light. Alternatively, the first to third light emitting elements ED1, ED2, ED3 may emit light of different colors from each other. In an embodiment, for example, the first to third light emitting elements ED1, ED2, ED3 may respectively emit red light, green light, and blue light.

The cathode electrode CATH may be disposed on the light emitting element ED. The cathode electrode CATH may include a metal, a metal oxide, or a metal nitride.

The thin film encapsulation layer may be disposed on the cathode electrode CATH. The thin film encapsulation layer may serve to protect the light emitting element ED from external moisture, heat, impact, and the like. The thin film encapsulation layer may have a structure in which a first inorganic thin film encapsulation layer IL1, an organic thin film encapsulation layer OL, and a second inorganic thin film encapsulation layer IL2 are stacked one on another. The organic thin film encapsulation layer OL may have a relatively thick thickness and a flat top surface compared to the first and second inorganic thin film encapsulation layers IL1 and IL2 .

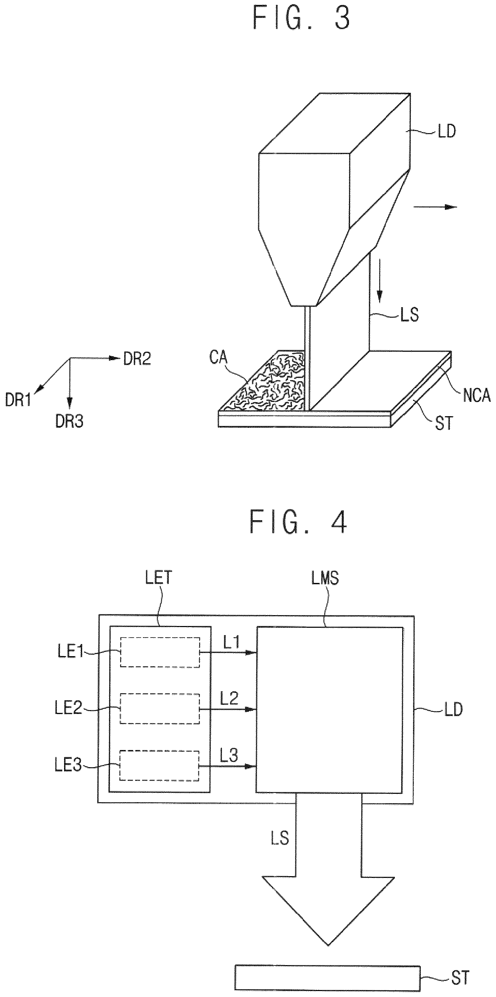

FIG 3 is a perspective view illustrating an embodiment of a laser crystallization device for forming an active layer included in the display device of FIG 2.

Referring to FIGS. 2 and 3, an amorphous silicon thin film NCA may be disposed on the stage ST. The amorphous silicon thin film NCA may not be disposed alone, but may be disposed on the stage ST together with a separate configuration. In an embodiment, for example, the amorphous silicon thin film NCA may be disposed on the stage ST while disposed on the substrate SUB. The amorphous silicon thin film NCA may be referred to as a preliminary active layer. That is, the preliminary active layer may include amorphous silicon.

The laser crystallization device LD may radiate the integrated solid-state laser LS onto the amorphous silicon thin film NCA on the stage ST. The integrated solid-state laser LS may refer to a laser in which a plurality of solid-state lasers are combined with each other. In an embodiment, for example, the integrated solid-state laser LS may be radiated while the laser crystallization device LD moves in the second direction DR2. Alternatively, the stage ST may move in a direction opposite to the second direction DR2, and the laser crystallization device LD may radiate the integrated solid-state laser LS in a fixed state. In an embodiment, the integrated solid-state laser LS may be a solid-state laser that generates a laser using a solid-state laser medium.

The amorphous silicon thin film NCA may be crystallized into a polycrystalline silicon thin film CA by the laser LS. The polysilicon thin film CA may correspond to the active layer ACT and may be referred to as the active layer ACT. That is, the active layer ACT may include polycrystalline silicon.

The integrated solid-state laser LS may be radiated in the form of a line beam extending in one direction. In an embodiment, for example, the line beam may extend in a first direction DR1 perpendicular to a second direction DR2 that is a moving direction of the laser crystallization device LD. In FIG 3, a third direction DR3 may be a direction perpendicular to the first direction DR1 and the second direction DR2, or a thickness direction of the stage ST.

FIG 4 is a view illustrating an embodiment of the laser crystallization device of FIG 3.

Referring to FIG 4, an embodiment of the laser crystallization device LD may include a solid-state laser generator LET and a lens-mirror array LMS. The solid-state laser generator LET includes a first solid-state laser generator LE1, a second solid-state laser generator LE2, and a third solid-state laser generator LE3. The lens-mirror array LMS may include a plurality of lenses and a plurality of mirrors.

The solid-state laser generator LET may generate a solid-state laser using a solid-state laser medium therein. In an embodiment, the first solid-state laser generator LE1, the second solid-state laser generator LE2, and the third solid-state laser generator LE3 may each include a same solid-state laser medium or may include different solid-state laser media. The solid-state laser medium may include a material in which active atoms or active molecules are uniformly distributed. In an embodiment, for example, solid-state laser medium may include at least one selected from ruby ("Cr:Al₂O₃"), neodymium yag ("Nd:YAG"), ytterbium yag ("Yb:YAG"), neodymium yttrium ("Nd:YVO₄"), neodymium yttrium lithium fluoride ("Nd:YLiF₄"), and the like, and the wavelength of the solid-state laser output may be determined based on the material of each medium, for example, but not being limited thereto. Alternatively, the solid-state laser medium may include various materials capable of generating a solid-state laser.

The first solid-state laser generator LE1, the second solid-state laser generator LE2, and the third solid-state laser generator LE3 generate solid-state lasers having different energy intensities, respectively. A first solid-state laser L1 generated by the first solid-state laser generator LE1 has a higher energy intensity than the second solid-state laser L2 generated by the second solid-state laser generator LE2. According to the present invention, the second solid-state laser L2 has an energy intensity in a range of about 48 percent to about 54 percent of an energy intensity of the first solid-state laser L1. The first solid-state laser L1 generated by the first solid--state laser generator LE1 has a higher energy intensity than the third solid-state laser L3 generated by the third solid-state laser generator LE3. Further according to the present invention, the third solid-state laser L3 has an energy intensity in a range of about 54 percent to about 60 percent of the energy intensity of the first solid-state laser.

The first to third solid-state lasers L1, L2, L3 may be radiated with a time difference, respectively. In an embodiment, for example, the second solid-state laser generator LE2 may radiate the second solid-state laser L2 about 5 to about 30 nanoseconds after the first solid-state laser generator LE1 radiates the first solid-state laser L1. The third solid-state laser generator LE3 may radiate the third solid-state laser L3 about 30 to about 95 nanoseconds after the first solid-state laser generator LE1 radiates the first solid-state laser L1.

When crystallizing amorphous silicon into polycrystalline silicon, a laser crystallization device LD melts the amorphous silicon and then solidifies to obtain polycrystalline silicon. The first solid-state laser L1 and the second solid-state laser L2 affect a melting time, which is a time taken when the amorphous silicon is melted. The third solid-state laser L3 affects a solidification time, which is a time taken for the molten amorphous silicon to solidify. When crystallizing amorphous silicon into polycrystalline silicon using a laser crystallization device, it is desired to increase the melting time and solidification time of amorphous silicon to improve the crystallization arrangement. Accordingly, an embodiment of the laser crystallization device LD may increase the melting time and solidification time of amorphous silicon by radiating a plurality of solid-state lasers L1, L2, L3 with a time difference rather than radiating a single solid-state laser.

The lens-mirror array LMS may control a path along which the first to third solid-state lasers L1, L2, L3 travel by using a lens and a mirror. Also, the lens-mirror array LMS may improve the homogeneity of the first to third solid-state lasers L1, L2, L3 using a lens and a mirror.

The first to third solid-state lasers L1, L2, L3 pass through the lens-mirror array LMS and may be radiated onto the stage ST as an integrated solid-state laser LS. The integrated solid-state laser LS may be a laser in which the first to third solid-state lasers L1, L2, L3 are combined with each other. The integrated solid-state laser LS may have peaks representing various energy intensities. Each of the peaks may have a size corresponding to the energy intensity of a corresponding one of the first to third solid-state lasers L1, L2, L3.

Various configurations may be further provided or disposed on the stage ST. In an embodiment, for example, a preliminary active layer may be disposed on the stage ST. The integrated solid-state laser LS may be radiated to the preliminary active layer to crystallize the preliminary active layer into an active layer.

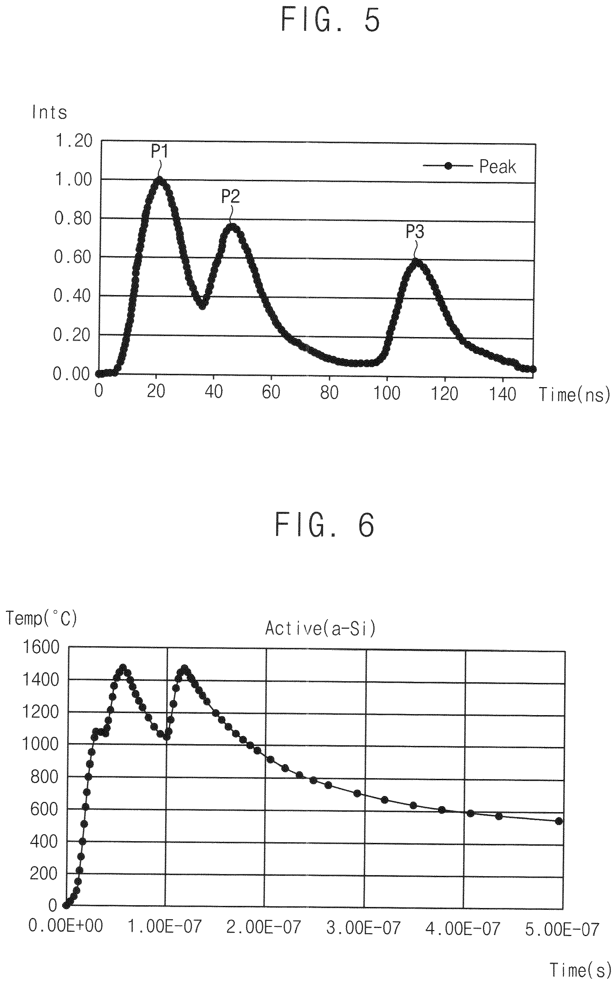

FIG 5 is a view illustrating an energy intensity of a laser generated in the laser crystallization device of FIG 4.

Referring to FIGS. 4 and 5, FIG 5 shows the energy intensity of the integrated solid-state laser LS based on the energy intensity of the first solid-state laser L1. That is, in the graph of FIG 5, the energy intensity of each of the first solid-state laser L1, the second solid-state laser L2, and the third solid-state laser L3 is divided by the energy intensity of the first solid-state laser L1. The first peak P1 is relatively expressed by dividing the energy intensity of the first solid-state laser L1 by the energy intensity of the first solid-state laser L1. Accordingly, the first peak P1 may have a maximum value of 1. The second peak P2 is a relative representation of the energy intensity of the second solid-state laser L2 divided by the energy intensity of the first solid-state laser L1, and the third peak P3 is the energy intensity of the third solid-state laser L3. The energy intensity is divided by the energy intensity of the first solid-state laser L1 to be relatively expressed.

In order for the integrated solid-state laser LS to crystallize the preliminary active layer into an active layer, it is desired to have energy of a certain intensity or more. In an embodiment, for example, the energy intensity of the integrated solid-state laser LS is in a range of about 260 millijoule per square centimeter (mJ/cm²) to about 300 mJ/cm². In such an embodiment, the energy intensity of the integrated solid-state laser LS means the sum of the energy intensity of each of the first to third solid-state lasers L1, L2, L3. The energy intensity of the second solid-state laser L2 is in a range of about 48 percent to about 54 percent of the energy intensity of the first solid-state laser L1. The energy intensity of the third solid-state laser L3 is in a range of about 54 percent to about 60 percent of the energy intensity of the first solid-state laser L1. In such an embodiment, the energy intensity of the third solid-state laser L3 is greater than that of the second solid-state laser L2.

However, in FIG 5, the second peak P2 relatively indicating the energy intensity of the second solid-state laser L2 is higher than the third peak P3 relatively indicating the energy intensity of the third solid-state laser L3. The second peak P2 is higher due to the influence of the first solid-state laser L1.

In an embodiment, for example, the energy intensity of the integrated solid-state laser LS may be about 280 mJ/cm². In such an embodiment, the energy intensity of the first solid-state laser L1 is about 138.6 mJ/cm², and the energy intensity of the second solid-state laser L2 is about 66.5 mJ/cm², which is about 48 percent of the energy intensity of the first solid-state laser L1, and the energy intensity of the third solid-state laser L3 may be about 74.8 mJ/ cm², which is about 54 percent of the energy intensity of the first solid-state laser L1.

A full width at half maximum of each of the first to third solid-state lasers L1, L2, L3 may be in a range of about 12 nanoseconds to about 17 nanoseconds. The full width at half maximum may mean the width of a spectrum having an energy intensity corresponding to half of the maximum energy intensity of the solid-state laser.

Since the first solid-state laser L1 and the second solid-state laser L2 are separately generated by dividing the timing, the melting time of the preliminary active layer to which the first solid-state laser L1 and the second solid-state laser L2 is radiated may increase. When the temperature of the preliminary active layer melted by the first solid-state laser L1 starts to decrease, the preliminary active layer may be melted again by further radiating the second solid-state laser L2.

Since the third solid-state laser L3 is generated separately from the first solid-state laser L1 and the second solid-state laser L2 and is radiated to the preliminary active layer, the temperature of the preliminary active layer in which solidification is in progress may be increased. Accordingly, the time for the preliminary active layer to be solidified may increase, such that the laser crystallization device LD may increase the crystallinity of the active layer.

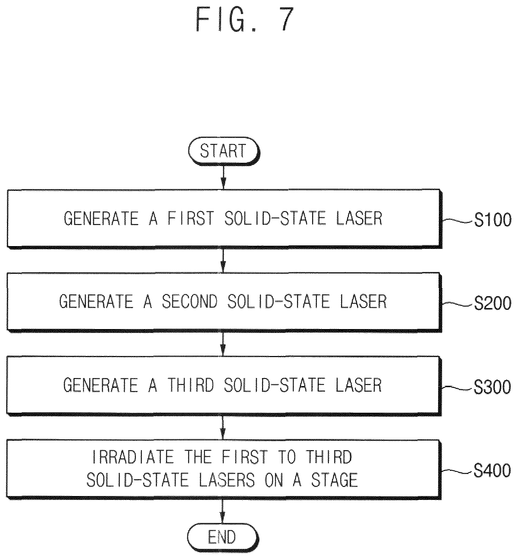

FIG 6 is a view illustrating a temperature of a preliminary active layer crystallized by a laser generated in the laser crystallization device of FIG 4 and FIG 7 is a flowchart illustrating an embodiment of a laser crystallization method.

Referring to FIGS. 4, 6 and 7, FIG 6 illustrates a temperature change of a preliminary active layer including amorphous silicon. The laser crystallization device LD may generate the first solid-state laser L1 (S100), generate the second solid-state laser L2 (S200), and generate the third solid-state laser L3 (S300). The generated first to third solid-state lasers L1, L2, L3 may be sequentially radiated onto the stage ST (S400). First, when the first solid-state laser L1 is radiated to the preliminary active layer, the temperature of the preliminary active layer is raised to about 1100° C in about 18 to about 20 nanoseconds by the first solid-state laser L1.

Thereafter, when the second solid-state laser L2 is radiated to the preliminary active layer, the temperature of the preliminary active layer is raised to about 1500° C in about 45 to about 50 nanoseconds by the second solid-state laser L2. As described above, by separately generating the first solid-state laser L1 and the second solid-state laser L2 to irradiate a same preliminary active layer, the melting time of the preliminary active layer may be increased. After that, the temperature of the preliminary active layer may be lowered and the preliminary active layer may be solidified.

After the second solid-state laser L2 is radiated, when the third solid-state laser L3 is radiated to the preliminary active layer, the preliminary active layer is irradiated in about 105 to about 115 nanoseconds by the third solid-state laser L3. The temperature of the active layer rises again to about 1500 °C by radiating the third solid-state laser L3 to the preliminary active layer. In this case, since the solidified preliminary active layer is melted again, the total time for solidification of the preliminary active layer may be increased.

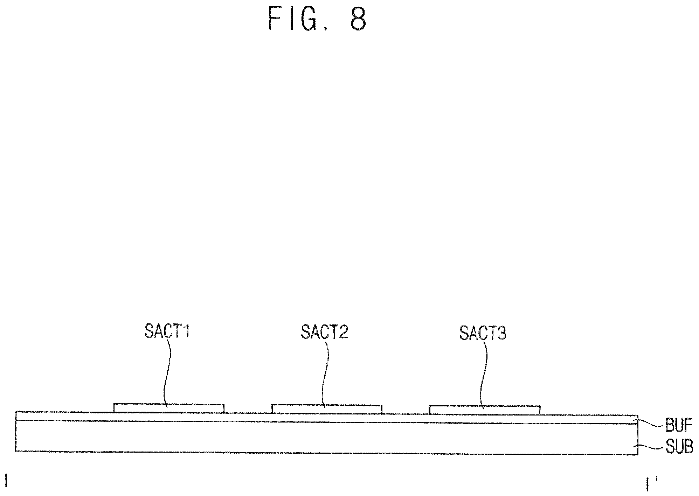

FIGS. 8, 9, 10 and 11 are cross-sectional views illustrating an embodiment of a method of manufacturing the display device.

Referring to FIG 8, a substrate SUB may be provided or prepared. The buffer layer BUF may be provided or formed on the substrate SUB. The preliminary active layers SACT1, SACT2, SACT3 may be provided or formed on the substrate SUB. The preliminary active layers SACT1, SACT2, SACT3 may include amorphous silicon.

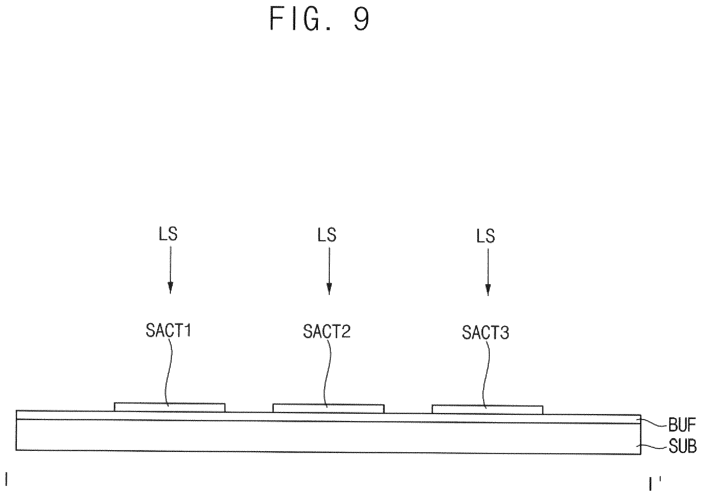

Referring to FIG 9, the integrated solid-state laser LS may be radiated to the preliminary active layers SACT1, SACT2, SACT3. The integrated solid-state laser LS may crystallize the preliminary active layers SACT1, SACT2, SACT3.

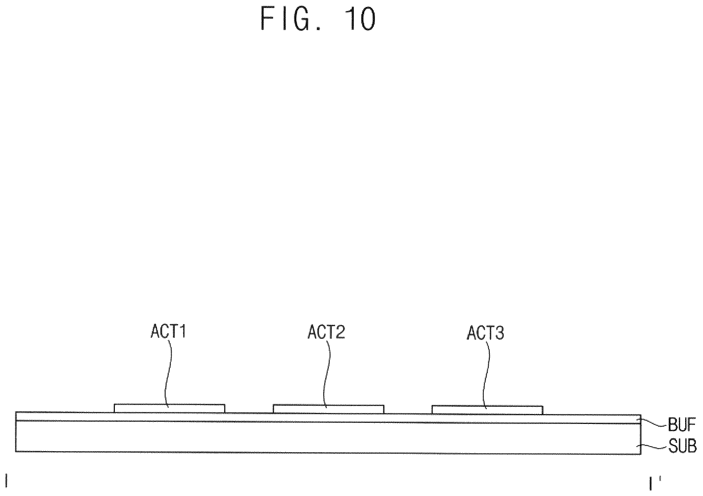

Referring to FIG 10, the preliminary active layers SACT1, SACT2, SACT3 may be irradiated with the integrated solid-state laser LS to be crystallized into the active layers ACT1, ACT2, ACT3. The active layers ACT1, ACT2, ACT3 may include polycrystalline silicon.

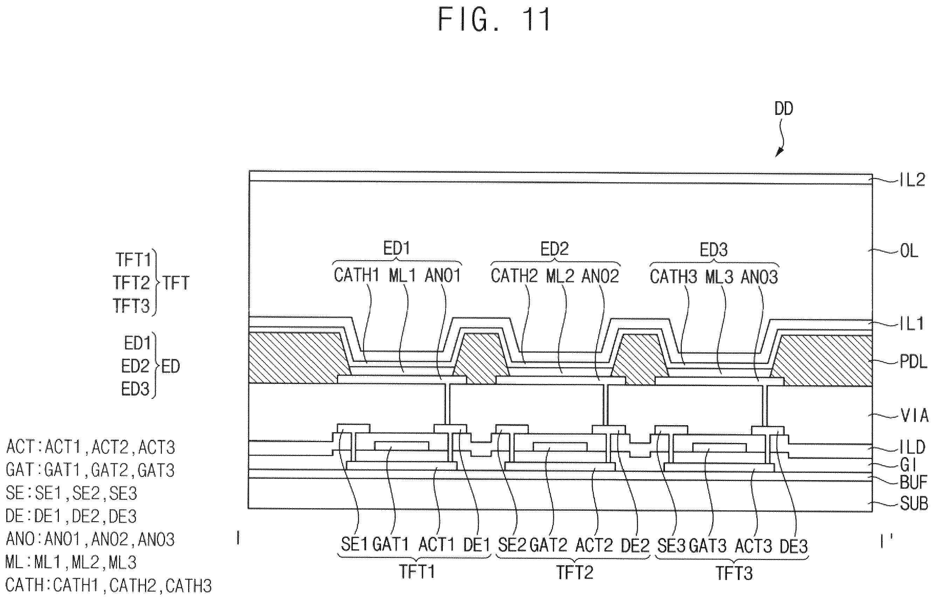

Referring to FIG 11, the gate electrode GAT may be provided or formed on the active layer ACT. The source electrode SE and the drain electrode DE may be provided or formed on the gate electrode GAT. The anode electrode ANO may be provided or formed on the source electrode SE and the drain electrode DE. The intermediate layer ML may be provided or formed on the anode electrode ANO. The cathode electrode CATH may be provided or formed on the intermediate layer ML. The thin film encapsulation layers IL1, OL, IL2 may be provided or formed on the intermediate layer ML.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A laser crystallization device (LD), comprising:
a first solid-state laser generator (LE1) configured to generate a first solid-state laser (L1) having a first energy intensity;
the device being **characterised by**:
a second solid-state laser generator (LE2) configured to generate a second solid-state laser (L2) having a second energy intensity lower than the first energy intensity, wherein the second energy intensity is in a range of about 48 percent to about 54 percent of the first energy intensity; and
a third solid-state laser generator (LE3) configured to generate a third solid-state laser (L3) having a third energy intensity lower than the first energy intensity, wherein the third energy intensity is in a range of about 54 percent to about 60 percent of the first energy intensity, and
the third energy intensity is greater than the second energy intensity.

2. The laser crystallization device (LD) of claim 1,
wherein the second solid-state laser generator (LE2) is configured to radiate the second solid-state laser (L2) about 5 nanoseconds to about 30 nanoseconds after the first solid-state laser generator (LE2) radiates the first solid-state laser (L1), and
wherein the third solid-state laser generator (LE3) is configured to radiate the third solid-state laser (L3) about 30 nanoseconds to about 95 nanoseconds after the first solid-state laser generator (LE1) radiates the first solid-state laser (L1).

3. The laser crystallization device (LD) of any one of claims 1 or 2, wherein:
(i) each of the first to third solid-state laser generators (LE1, LE2, LE3) includes a solid-state laser medium; and/or
(ii) a full width at half maximum of each of the first to third solid-state lasers (L1, L2, L3) is in a range of about 12 nanoseconds to about 17 nanoseconds.

4. A laser crystallization method, comprising:
generating a first solid-state laser (L1) having a first energy intensity;
the method being **characterised by** the following steps:
generating a second solid-state laser (L2) having a second energy intensity lower than the first energy intensity, wherein the second energy intensity is in a range of about 48 percent to about 54 percent of the first energy intensity;
generating a third solid-state laser (L3) having a third energy intensity lower than the first energy intensity and greater than the second energy intensity, wherein the third energy intensity is in a range of about 54 percent to about 60 percent of the first energy intensity; and
radiating the first solid-state laser (L1), the second solid-state laser (L2), and the third solid-state laser (L3) sequentially onto a stage (ST).

5. The laser crystallization method of claim 4,
wherein the second solid-state laser (L2) is radiated about 5 nanoseconds to about 30 nanoseconds after the first solid-state laser (L1) is radiated, and
wherein the third solid-state laser (L3) is radiated about 30 nanoseconds to about 95 nanoseconds after the first solid-state laser (L1) is radiated.

6. The laser crystallization method of any one of claims 4 or 5, wherein:
(i) a full width at half maximum of each of the first to third solid-state lasers (L1, L2, L3) is in a range of about 12 nanoseconds to about 17 nanoseconds; and/or
(ii) each of the first to third solid-state lasers (L1, L2, L3) is generated using a solid-state laser medium.

7. A method of manufacturing a display device using the laser crystallization method of claim 4, the method comprising:
providing a preliminary active layer on a substrate (SUB);
first crystallizing the preliminary active layer by radiating a first solid-state laser (L1) having a first energy intensity onto the preliminary active layer;
second crystallizing of the preliminary active layer by radiating a second solid-state laser (L2) having a second energy intensity lower than the first energy intensity onto the preliminary active layer, wherein the second energy intensity is in a range of about 48 percent to about 54 percent of the first energy intensity; and
third crystallizing of the preliminary active layer by radiating a third solid-state laser (L3) having a third energy intensity lower than the first energy intensity and greater than the second energy intensity onto the preliminary active layer, wherein the third energy intensity is in a range of about 54 percent to about 60 percent of the first energy intensity.

8. The method of claim 7,
wherein the second solid-state laser (L2) is radiated about 5 nanoseconds to about 30 nanoseconds after the first solid-state laser (L1) is radiated, and
wherein the third solid-state laser (L3) is radiated about 30 nanoseconds to about 95 nanoseconds after the first solid-state laser (L1) is radiated.

9. The method of any one of claims 7 or 8, wherein a full width at half maximum of each of the first to third solid-state lasers (L3) is in a range of about 12 nanoseconds to about 17 nanoseconds.

10. The method of claim 7, wherein
the second energy intensity is in a range of about 48 percent to about 54 percent of the first energy intensity,
wherein the third energy intensity is in a range of about 54 percent to about 60 percent of the first energy intensity, and
wherein the second solid-state laser (L2) is radiated about 5 nanoseconds to about 30 nanoseconds after the first solid-state laser (L1) is radiated, and the third solid-state laser (L3) is radiated about 30 nanoseconds to about 95 nanoseconds after the first solid-state laser (L1) is radiated.

11. The method of any one of claims 7 to 10, wherein each of the first to third solid-state lasers (L1, L2, L3) is generated using a solid-state laser medium.

## Patentansprüche

1. Laserkristallisationsvorrichtung (LD), die Folgendes umfasst:
einen ersten Festkörperlasergenerator (LE1), der dazu konfiguriert ist, einen ersten Festkörperlaser (L1), der eine erste Energieintensität aufweist, zu erzeugen;
wobei die Vorrichtung **gekennzeichnet ist durch**:
einen zweiten Festkörperlasergenerator (LE2), der dazu konfiguriert ist, einen zweiten Festkörperlaser (L2), der eine zweite Energieintensität aufweist, zu erzeugen, die niedriger ist als die erste Energieintensität, wobei die zweite Energieintensität in einem Bereich von etwa 48 Prozent bis etwa 54 Prozent der ersten Energieintensität liegt; und
einen dritten Festkörperlasergenerator (LE3), der dazu konfiguriert ist, einen dritten Festkörperlaser (L3), der eine dritte Energieintensität aufweist, zu erzeugen, die niedriger ist als die erste Energieintensität, wobei die dritte Energieintensität in einem Bereich von etwa 54 Prozent bis etwa 60 Prozent der ersten Energieintensität liegt und die dritte Energieintensität größer ist als die zweite Energieintensität.

2. Laserkristallisationsvorrichtung (LD) nach Anspruch 1,
wobei der zweite Festkörperlasergenerator (LE2) dazu konfiguriert ist, den zweiten Festkörperlaser (L2) etwa 5 Nanosekunden bis etwa 30 Nanosekunden ausstrahlt, nachdem der erste Festkörperlasergenerator (LE2) den ersten Festkörperlaser (L1) ausstrahlt, und
wobei der dritte Festkörperlasergenerator (LE3) dazu konfiguriert ist, den dritten Festkörperlaser (L3) etwa 30 Nanosekunden bis etwa 95 Nanosekunden, nachdem der erste Festkörperlasergenerator (LE1) den ersten Festkörperlaser (L1) ausstrahlt, auszustrahlen.

3. Laserkristallisationsvorrichtung (LD) nach einem der Ansprüche 1 oder 2, wobei:
(i) jeder des ersten bis dritten Festkörperlasergenerators (LE1, LE2, LE3) ein Festkörperlasermedium einschließt; und/oder
(ii) eine Halbwertsbreite jedes der ersten bis dritten Festkörperlasers (L1, L2, L3) in einem Bereich von etwa 12 Nanosekunden bis etwa 17 Nanosekunden liegt.

4. Laserkristallisationsverfahren, das Folgendes umfasst:
Erzeugen eines ersten Festkörperlasers (L1), der eine erste Energieintensität aufweist;
wobei das Verfahren durch die folgenden Schritte gekennzeichnet ist:
Erzeugen eines zweiten Festkörperlasers (L2), der eine zweite Energieintensität aufweist, die niedriger ist als die erste Energieintensität, wobei die zweite Energieintensität in einem Bereich von etwa 48 Prozent bis etwa 54 Prozent der ersten Energieintensität liegt;
Erzeugen eines dritten Festkörperlasers (L3), der eine dritte Energieintensität aufweist, die niedriger als die erste Energieintensität und höher als die zweite Energieintensität ist, wobei die dritte Energieintensität in einem Bereich von etwa 54 Prozent bis etwa 60 Prozent der ersten Energieintensität liegt; und
Ausstrahlen des ersten Festkörperlasers (L1), des zweiten Festkörperlasers (L2) und des dritten Festkörperlasers (L3) nacheinander auf eine Bühne (ST).

5. Laserkristallisationsverfahren nach Anspruch 4,
wobei der zweite Festkörperlaser (L2) etwa 5 Nanosekunden bis etwa 30 Nanosekunden ausgestrahlt wird, nachdem der erste Festkörperlaser (L1) ausgestrahlt wird, und
wobei der dritte Festkörperlaser (L3) etwa 30 Nanosekunden bis etwa 95 Nanosekunden ausgestrahlt wird, nachdem der erste Festkörperlaser (L1) ausgestrahlt wird.

6. Laserkristallisationsverfahren nach einem der Ansprüche 4 oder 5, wobei:
(i) eine Halbwertsbreite jedes des ersten bis dritten Festkörperlasers (L1, L2, L3) in einem Bereich von etwa 12 Nanosekunden bis etwa 17 Nanosekunden liegt; und/oder
(ii) jeder des ersten bis dritten Festkörperlasers (L1, L2, L3) unter Verwendung eines Festkörperlasermediums erzeugt wird.

7. Verfahren zum Herstellen einer Anzeigevorrichtung unter Verwendung des Laserkristallisationsverfahrens nach Anspruch 4, wobei das Verfahren Folgendes umfasst:
Bereitstellen einer vorläufigen aktiven Schicht auf einem Substrat (SUB);
erstes Kristallisieren der vorläufigen aktiven Schicht durch Strahlen eines ersten Festkörperlasers, der eine erste Energieintensität aufweist, auf die vorläufige aktive Schicht;
zweites Kristallisieren der vorläufigen aktiven Schicht durch Strahlen eines zweiten Festkörperlasers (L2), der eine zweite Energieintensität aufweist, die geringer ist als die erste Energieintensität, auf die vorläufige aktive Schicht, wobei die zweite Energieintensität in einem Bereich von etwa 48 Prozent bis etwa 54 Prozent der ersten Energieintensität liegt; und
drittes Kristallisieren der vorläufigen aktiven Schicht durch Strahlen eines dritten Festkörperlasers (L3), der eine dritte Energieintensität aufweist, die niedriger als die erste Energieintensität und höher als die zweite Energieintensität ist, wobei die dritte Energieintensität in einem Bereich von etwa 54 Prozent bis etwa 60 Prozent der ersten Energieintensität liegt.

8. Verfahren nach Anspruch 7,
wobei der zweite Festkörperlaser (L2) etwa 5 Nanosekunden bis etwa 30 Nanosekunden ausgestrahlt wird, nachdem der erste Festkörperlaser (L1) ausgestrahlt wird, und
wobei der dritte Festkörperlaser (L3) etwa 30 Nanosekunden bis etwa 95 Nanosekunden ausgestrahlt wird, nachdem der erste Festkörperlaser (L1) ausgestrahlt wird.

9. Verfahren nach einem der Ansprüche 7 oder 8, wobei eine Halbwertsbreite jedes der ersten bis dritten Festkörperlaser (L3) in einem Bereich von etwa 12 Nanosekunden bis etwa 17 Nanosekunden liegt.

10. Verfahren nach Anspruch 7, wobei
die zweite Energieintensität in einem Bereich von etwa 48 Prozent bis etwa 54 Prozent der ersten Energieintensität liegt,
wobei die dritte Energieintensität in einem Bereich von etwa 54 Prozent bis etwa 60 Prozent der ersten Energieintensität liegt, und
wobei der zweite Festkörperlaser (L2) etwa 5 Nanosekunden bis etwa 30 Nanosekunden ausgestrahlt wird, nachdem der erste Festkörperlaser (L1) ausgestrahlt wird, und der dritte Festkörperlaser (L3) etwa 30 Nanosekunden bis etwa 95 Nanosekunden ausgestrahlt wird, nachdem der erste Festkörperlaser (L1) ausgestrahlt wird.

11. Verfahren nach einem der Ansprüche 7 bis 10, wobei jeder des ersten bis dritten Festkörperlasers (L1, L2, L3) unter Verwendung eines Festkörperlasermediums erzeugt wird.

## Revendications

1. Dispositif de cristallisation par laser (LD), comprenant :
un premier générateur laser l'état solide (LE1) configuré pour générer un premier laser à l'état solide (L1) présentant une première intensité énergétique ;
le dispositif étant **caractérisé en ce que** :
un deuxième générateur laser à l'état solide (LE2) configuré pour générer un deuxième laser à l'état solide (L2) présentant une deuxième intensité énergétique inférieure à la première intensité énergétique, dans lequel la deuxième intensité énergétique est dans une plage d'environ 48 pour cent à environ 54 pour cent de la première intensité énergétique ; et
un troisième générateur laser à l'état solide (LE3) configuré pour générer un troisième laser à l'état solide (L3) présentant une troisième intensité énergétique inférieure à la première intensité énergétique, dans lequel la troisième intensité énergétique est dans une plage d'environ 54 pour cent à environ 60 pour cent de la première intensité énergétique, et la troisième intensité énergétique étant supérieure à la deuxième intensité énergétique.

2. Dispositif de cristallisation par laser (LD) selon la revendication 1,
dans lequel le deuxième générateur laser à l'état solide (LE2) est configuré pour irradier le deuxième laser à l'état solide (L2) environ 5 nanosecondes à environ 30 nanosecondes après que le premier générateur laser à l'état solide (LE2) a irradié le premier laser à l'état solide (L1), et
dans lequel le troisième générateur laser à l'état solide (LE3) est configuré pour irradier le troisième laser à l'état solide (L3) environ 30 nanosecondes à environ 95 nanosecondes après que le premier générateur laser à l'état solide (LE1) a irradié le premier laser à l'état solide (L1).

3. Dispositif de cristallisation par laser (LD) selon l'une quelconque des revendications 1 ou 2, dans lequel :
(i) chacun des premier à troisième générateurs laser à l'état solide (LE1, LE2, LE3) inclut un milieu laser à l'état solide ; et/ou
(ii) une largeur totale à mi-hauteur de chacun des premier à troisième lasers à l'état solide (L1, L2, L3) est dans une plage d'environ 12 nanosecondes à environ 17 nanosecondes.

4. Procédé de cristallisation par laser, comprenant :
la génération d'un premier laser à l'état solide (L1) présentant une première intensité énergétique ;
le procédé étant **caractérisé par** les étapes suivantes :
la génération d'un deuxième laser à l'état solide (L2) présentant une deuxième intensité énergétique inférieure à la première intensité énergétique, dans lequel la deuxième intensité énergétique est dans une plage d'environ 48 pour cent à environ 54 pour cent de la première intensité énergétique ;
la génération d'un troisième laser à l'état solide (L3) présentant une troisième intensité énergétique inférieure à la première intensité énergétique et supérieure à la deuxième intensité énergétique, dans lequel la troisième intensité énergétique est dans une plage d'environ 54 pour cent à environ 60 pour cent de la première intensité énergétique ; et
l'irradiation du premier laser à l'état solide (L1), du deuxième laser à l'état solide (L2) et du troisième laser à l'état solide (L3) de manière séquentielle sur une platine (ST).

5. Procédé de cristallisation par laser selon la revendication 4,
dans lequel le deuxième laser à l'état solide (L2) est irradié environ 5 nanosecondes à environ 30 nanosecondes après le rayonnement du premier laser à l'état solide (L1), et
dans lequel le troisième laser à l'état solide (L3) est irradié environ 30 nanosecondes à environ 95 nanosecondes après que le premier laser à l'état solide (L1) a été irradié.

6. Procédé de cristallisation au laser selon l'une quelconque des revendications 4 ou 5, dans lequel :
(i) une largeur totale à mi-hauteur de chacun des premier à troisième lasers à l'état solide (L1, L2, L3) est dans une plage d'environ 12 nanosecondes à environ 17 nanosecondes ; et/ou
(ii) chacun des premier à troisième lasers à l'état solide (L1, L2, L3) est généré à l'aide d'un milieu laser à l'état solide.

7. Procédé de fabrication d'un dispositif d'affichage à l'aide du procédé de cristallisation par laser selon la revendication 4, le procédé comprenant :
la fourniture d'une couche active préliminaire sur un substrat (SUB) ;
une première cristallisation de la couche active préliminaire en irradiant un premier laser à l'état solide (L1) présentant une première intensité énergétique sur la couche active préliminaire ;
une deuxième cristallisation de la couche active préliminaire en irradiant un deuxième laser à l'état solide (L2) présentant une deuxième intensité énergétique inférieure à la première intensité énergétique sur la couche active préliminaire, dans lequel la deuxième intensité énergétique est dans une plage d'environ 48 pour cent à environ 54 pour cent de la première intensité énergétique ; et
une troisième cristallisation de la couche active préliminaire en irradiant un troisième laser à l'état solide (L3) présentant une troisième intensité énergétique inférieure à la première intensité énergétique et supérieure à la deuxième intensité énergétique sur la couche active préliminaire dans lequel, la troisième intensité énergétique est dans une plage d'environ 54 pour cent à environ 60 pour cent de la première intensité énergétique.

8. Procédé selon la revendication 7,
dans lequel le deuxième laser à l'état solide (L2) est irradié environ 5 nanosecondes à environ 30 nanosecondes après que le premier laser à l'état solide est irradié (L1), et
dans lequel le troisième laser à l'état solide (L3) est irradié environ 30 nanosecondes à environ 95 nanosecondes après que le premier laser à l'état solide (L1) est irradié.

9. Procédé selon l'une quelconque des revendications 7 ou 8, dans lequel une largeur totale à mi-hauteur de chacun des premier à troisième lasers à l'état solide (L3) est dans une plage d'environ 12 nanosecondes à environ 17 nanosecondes.

10. Procédé selon la revendication 7, dans lequel
la deuxième intensité énergétique est dans une plage d'environ 48 à environ 54 pour cent de la première intensité énergétique,
dans lequel la troisième intensité énergétique est dans une plage d'environ 54 à environ 60 pour cent de la première intensité énergétique, et
dans lequel le deuxième laser à l'état solide (L2) est irradié environ 5 nanosecondes à environ 30 nanosecondes après que le premier laser à l'état solide (L1) est irradié, et le troisième laser à l'état solide (L3) est irradié environ 30 nanosecondes à environ 95 nanosecondes après que le premier laser à l'état solide (L1) est irradié.

11. Procédé selon l'une quelconque des revendications 7 à 10, dans lequel chacun des premier à troisième lasers à l'état solide (L1, L2, L3) est généré à l'aide d'un milieu laser à l'état solide.
